(19) Europäisches Patentamt
European Patent Office
Office européen des brevets

(11) **EP 2 667 509 B1**

(12) **EUROPÄISCHE PATENTSCHRIFT**

(45) Veröffentlichungstag und Bekanntmachung des Hinweises auf die Patenterteilung:
**18.07.2018  Patentblatt 2018/29**

(21) Anmeldenummer: **13002481.3**

(22) Anmeldetag: **10.05.2013**

(51) Int Cl.:
***H03H 17/06*** *(2006.01)*

(54) **Digitales Filter**

Digital filter

Filtre numérique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.05.2012  DE 102012010229**

(43) Veröffentlichungstag der Anmeldung:
**27.11.2013  Patentblatt 2013/48**

(73) Patentinhaber: **MBDA Deutschland GmbH 86529 Schrobenhausen (DE)**

(72) Erfinder: **Sedlak, Gerhard D-83233 Bernau am Chiemsee (DE)**

(74) Vertreter: **Isarpatent Patent- und Rechtsanwälte Behnisch Barth Charles Hassa Peckmann & Partner mbB Postfach 44 01 51 80750 München (DE)**

(56) Entgegenhaltungen:
EP-A2- 0 707 380       JP-A- 2010 130 185
US-A1- 2004 093 366   US-A1- 2007 230 642
US-B1- 7 170 956       US-B1- 7 170 959

**Beschreibung**

GEBIET DER ERFINDUNG

Die Erfindung betrifft ein digitales Filter sowie ein Verfahren zum Reduzieren einer Abtastrate eines Eingangssignals und einen Radarsensor für einen Flugkörpern.

HINTERGRUND DER ERFINDUNG

In der digitalen Signalverarbeitung, insbesondere bei schmalen Bandbreiten in Bezug auf die Abtastrate, werden häufig CIC-Filter (Cascaded-Integrator-Comb-Filter, Combination-Integrator-Comb-Filter oder kaskadiertes Integrator-Differentiator-Filter) verwendet, die einfach und kostengünstig zu realisieren sind. In vielen digitalen Filtern werden CIC-Filter auch in Kombination mit FIR-Filtern zum Anti-Aliasing von Signalen eingesetzt.

Aus der US 2004 0093366 A1 ist ein digitales Filter ("Infinite Impulse Response" Filter) bekannt, das mit parallelisierten Samplesignalen arbeiten und als Integrator in einem CIC-Filter eingesetzt werden kann.

Die Druckschrift EP 0 707 380 B1 offenbart einen Filter mit parallelen Eingängen mit kaskadierten Integratorkammpaaren.

ZUSAMMENFASSUNG DER ERFINDUNG

Der Standard-Algorithmus für CIC-Filter ist in der Regel nicht einsetzbar, wenn die Abtastwerte nach einem Analog/Digital-Wandler parallelisiert weiter verarbeitet werden müssen, beispielsweise wenn die Abtastrate zu hoch für die Signalverarbeitungs-Hardware ist.

Demgegenüber ist es Aufgabe der Erfindung, aus parallelen Rohsignalen das gleiche Zwischensignal zu erzeugen, wie aus dem Integrationsblock kombiniert mit dem Reduktionsblock eines herkömmlichen CIC-Filters.

Diese Aufgabe wird durch den Gegenstand der unabhängigen Ansprüche gelöst. Weitere Ausführungsformen der Erfindung ergeben sich aus den abhängigen Ansprüchen und aus der folgenden Beschreibung.

Ein Aspekt der Erfindung betrifft ein digitales Filter zum Reduzieren einer Abtastrate eines Signals, beispielsweise eines Eingangssignals, das von einem Analog/Digital-Wandler mit einer hohen Abtastrate erzeugt wird. Durch das Filter wird ein Ausgangssignal mit einer niedrigeren Abtastrate (beispielweise eine um wenigstens den Faktor 4 niedrigere Abtastrate) generiert, das einer digitalen Funktion zugeführt wird, die mit der niedrigeren Abtastrate arbeiten kann.

Es ist zu verstehen, dass das Eingangssignal, das Ausgangssignal und alle im Folgenden erwähnten Signale digitale Signale sind, also nur diskrete Signalpegel aufweisen können. Eine Abtastrate kann dadurch definiert sein, dass der diskrete Signalpegel jeweils nur nach einem vordefinierten diskreten Zeitschritt (dem Inversen der Abtastrate) wechseln kann.

Gemäß einer Ausführungsform der Erfindung umfasst das digitale Filter einen Parallelisierungsblock zum Aufspalten des Eingangssignals in wenigstens zwei parallele Rohsignale, wenigstens einen Integrationsblock zum Umwandeln der parallelen Rohsignale in ein Zwischensignal, und wenigstens einen Differentiationsblock zum Erzeugen eines Ausgangssignals durch Differenzieren des Zwischensignals. Der Integrationsblock umfasst einen Logikblock, der dazu ausgeführt ist, durch Summationsoperationen aus den parallelen Rohsignalen zwei parallele Summensignale zu erzeugen. Der Integrationsblock umfasst weiter einen Rekursionsblock, der dazu ausgeführt ist, aus den parallelen Summensignalen das Zwischensignal rekursiv zu erzeugen.

Anstatt ein serielles Signal mit einem herkömmlichen CIC-Filter zu verarbeiten, werden aus dem seriellen Eingangssignal beispielsweise 4 parallele Rohsignale erzeugt, die dann mittels des Integrationsblocks, der dazu ausgeführt ist, einen Rekursionsalgorithmus auszuführen, in ein Zwischensignal umgewandelt werden, das genauso von einem herkömmlichen CIC-Filter (Funktion vor dem Differentiationsblock) erzeugt werden könnte. Auf diese Weise kann die CIC-Filterwirkung für beispielsweise vierfach parallelisierte Abtastwerte erzielt werden.

Das Filter kann bei digitalen Schaltungen mit sehr hoher Abtastrate eingesetzt werden, bei denen eine Parallelisierung der Abtastwerte in der Hardware für die weitere Verarbeitung erforderlich sein kann. Da der Integrationsblock und der Differentiationsblock mit einer niedrigeren Abtastrate betrieben werden können, ist das Filter mit relativ geringem Aufwand zu realisieren.

Gemäß einer Ausführungsform der Erfindung werden die parallelen Summensignale zu einem Abtastzeitpunkt aus den parallelen Rohsignalen zum gleichen Abtastzeitpunkt erzeugt. Damit kann der Logikblock ohne Signale zwischenzuspeichern und/oder eine Rekursion auszuführen, diese parallelen Summensignale erzeugen.

Gemäß der Erfindung ist der Logikblock dazu ausgeführt, (genau) zwei parallele Summensignale $S_0$ und $S_1$ zu erzeugen, insbesondere gemäß

$$S_0(i) = \sum_{e=0}^{E-1} u_e(i), i = 1,2,\ldots$$

und

$$S_1(i) = E \cdot u_0(i) + \ldots + 2 \cdot u_{E-2}(i) + u_{E-1}(i), i = 1,2,\ldots,$$

wobei $u_e(i)$ die parallelen Rohsignale und E die Anzahl der parallelen Rohsignale sind. Wie weiter unten noch genauer ausgeführt wird, kann aus diesen beiden Summensignalen mittels Rekursion ein Zwischensignal erzeugt werden, dass dem entsprechenden Zwischensignal eines herkömmlichen CIC-Filters vor dem Differentiationsblock entspricht.

Gemäß einer Ausführungsform der Erfindung ist der Rekursionsblock dazu ausgeführt, das Zwischensignal zu einem Abtastzeitpunkt aus den parallelen Summensignalen zu diesem Abtastzeitpunkt und wenigstens einem vorhergehenden Abtastzeitpunkt zu erzeugen. Mit anderen Worten ist der Rekursionsblock in der Lage, Rekursionssignale bzw. daraus abgeleitete Signal zwischenzuspeichern.

Gemäß einer Ausführungsform der Erfindung ist der Rekursionsblock dazu ausgeführt, das Zwischensignal zu einem Abtastzeitpunkt aus den parallelen Summensignalen zu dem Abtastzeitpunkt und (lediglich) aus den parallelen Summensignalen, die um eine oder zwei Zeiteinheiten verzögert wurden, zu erzeugen. Auf diese Weise kann durch eine verhältnismäßig einfache Berechnung, die mit nur wenigen Logikoperationen (wie etwa Addieren, Subtrahieren und Zwischenspeichern) auskommt, das Zwischensignal erzeugt werden.

Gemäß der Erfindung ist der Rekursionsblock dazu ausgeführt, das Zwischensignal $S_R$ gemäß

$$S_R(i) = S_R(i-1) + S_1(i) + E \cdot S_0(i-2) + E \cdot S_0(i-1), i = 3,4,\ldots$$

zu erzeugen, wobei $S_0$ und $S_1$ die Summensignale und E die Anzahl der parallelen Rohsignale sind. Diese Rekursionsformel wird weiter unten abgeleitet. Damit kann der Rekursionsblock mit lediglich zweifachem Zwischenspeichern das Zwischensignal erzeugen. Weiter sind nur Multiplikationen mit einem Skalar und höchstens vier Additionen notwendig.

Gemäß einer Ausführungsform der Erfindung ist der Parallelisierungsblock dazu ausgeführt, das Eingangssignal in wenigstens vier, beispielsweise genau vier, parallele Rohsignale aufzuspalten. Auf diese Weise kann die nachfolgende Logik mit lediglich einem Viertel der ursprünglichen Abtastrate arbeiten.

Gemäß einer Ausführungsform der Erfindung weist der Differentiationsblock zwei seriell angeordnete Differentiationsstufen auf, die dazu ausgeführt sind, das um eine vordefinierte Anzahl von Zeiteinheiten verzögerte Zwischensignal von dem nicht verzögerten Zwischensignal abzuziehen. Dies entspricht einem Differentiationsblock eines herkömmlichen CIC-Filters, dem das Zwischensignal zugeführt wird.

Gemäß einer Ausführungsform der Erfindung sind die Differentiationsstufen dazu ausgeführt, das Zwischensignal um 4 oder 8 Zeiteinheiten zu verzögern.

Gemäß einer Ausführungsform der Erfindung ist das Filter in Hardware, beispielsweise mittels eines FPGA, ausgeführt. Da die Hardware mit einer niedrigeren Abtastrate arbeiten kann als der des Eingangssignals, kann hier eine kostengünstige Standard-Hardware eingesetzt werden. Alle bzw. ein Teil der Blöcke bzw. der Logik des digitalen Filters können als Operationsbausteine des FPGA realisiert sein.

Ein weiterer Aspekt der Erfindung betrifft den Radarsensor für einen Flugkörper, beispielsweise einen Lenkflugkörper oder einen militärischen Flugkörper.

Gemäß einer Ausführungsform der Erfindung umfasst der Flugkörper einen Radarempfänger, einen A/D-Wandler zum Wandeln eines analogen Signals aus dem Radarempfänger in ein digitales Signal und eine digitale Signalverarbeitung. Die digitale Signalverarbeitung, bei der es sich um einen Elektronikbaustein handeln kann, beinhaltet ein digitales Filter zum Reduzieren der Abtastrate des digitalen Signals, so wie es obenstehend und untenstehend beschrieben ist. Der Flugkörper kann mittels des Radarsensors ein potentielles Ziel erfassen und dann mit den ausgewerteten Signalen auf dieses Ziel zusteuern.

Ein weiterer Aspekt der Erfindung betrifft Verfahren zum Reduzieren einer Abtastrate eines Eingangssignals. Beispielsweise kann das Verfahren mit dem digitalen Filter durchgeführt werden.

Gemäß einer Ausführungsform der Erfindung umfasst das Verfahren die Schritte: Aufspalten des Eingangssignals in wenigstens zwei parallele Rohsignale; Summieren der parallelen Rohsignalen zu zwei parallelen Summensignalen; Rekursives Erzeugen eines Zwischensignals aus den parallelen Summensignalen; und Erzeugen eines Ausgangssignals durch Differenzieren des Zwischensignals.

Es ist zu verstehen, dass Merkmale des digitalen Filters und des Flugkörpers Merkmale des Verfahrens sein können und umgekehrt.

Im Folgenden werden Ausführungsbeispiele der Erfindung mit Bezug auf die beiliegenden Figuren detailliert beschrieben.

KURZE BESCHREIBUNG DER FIGUREN

Fig. 1 zeigt schematisch den Aufbau eines CIC-Filters.

Fig. 2 zeigt eine Transferfunktion für ein digitales Filter gemäß einer Ausführungsform der Erfindung.

Fig. 3 zeigt schematisch den Aufbau eines digitalen Filters gemäß einer Ausführungsform der Erfindung.

Fig. 4 zeigt schematisch einen Integrationsblock gemäß einer Ausführungsform der Erfindung.

Fig. 5 zeigt eine schematische Ansicht eines Flugkörpers gemäß einer Ausführungsform der Erfindung.

Grundsätzlich sind identische oder ähnliche Teile mit den gleichen Bezugszeichen versehen.

DETAILLIERTE BESCHREIBUNG VON AUSFÜHRUNGSBEISPIELEN

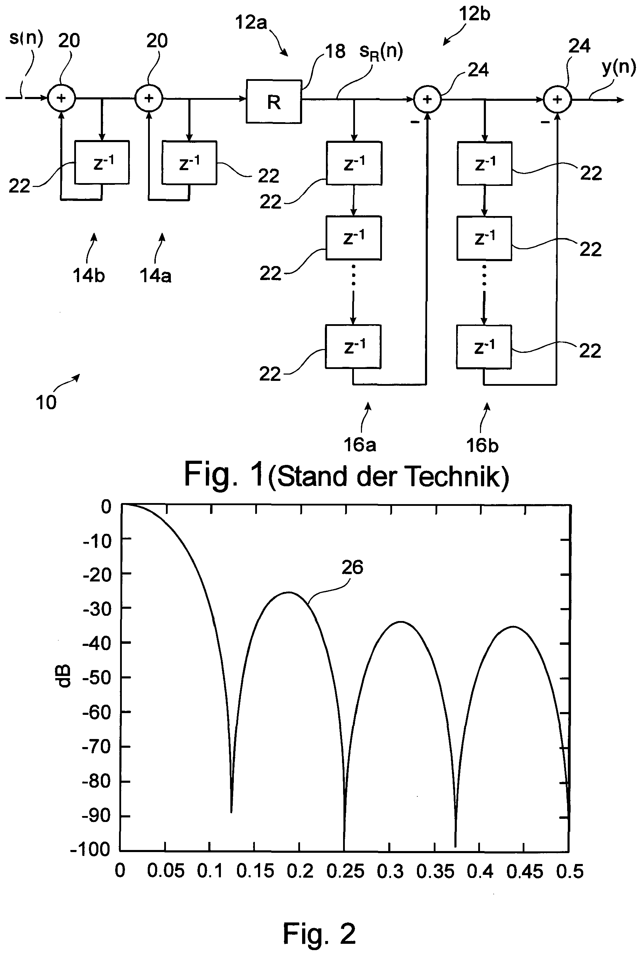

Fig. 1 zeigt einen herkömmlichen CIC-Filter 10, der zwei Stufen 12a, 12b umfasst. Die erste (innere) Stufe 12a umfasst einen ersten Integrationsblock 14a und einen ersten Differentiationsblock 16a. Die zweite (äußere) Stufe 12b umfasst einen zweiten Integrationsblock 14b und einen zweiten Differentiationsblock 16b. Die beiden Stufen 12a, 12b sind schachtelförmig ineinander angeordnet. Es ist zu verstehen, dass das CIC-Filter 10 auch mehr als zwei Stufen 12a, 12b aufweisen kann, die dann entsprechend ineinander geschachtelt sind.

Zwischen dem ersten Integrationsblock 14a und dem ersten Differentiationsblock 16a ist ein Reduktionsblock 18 zur Reduktion der Abtastrate angeordnet. Ein Eingangssignal s(n) (n ist dabei ein diskreter Zeitpunkt) durchläuft dabei die Integrationsblöcke 14b, 14a, den Reduktionsblock 18 und die Differentiationsblöcke 16a, 16b, wodurch durch den CIC-Filter 10 ein Ausgangssignal y(n) entsteht.

Die Integrationsblöcke 14a, 14b umfassen einen Additionsblock 20 und einen Zeitverzögerungsblock 22. Auf diese Weise wird beispielsweise im zweiten Integrationsblock 14a das Eingangssignal x(n) mit dem Eingangssignal x(n-1) einen diskreten Zeitschritt zuvor aufaddiert.

Jeder der Differentiationsblöcke 16a, 16b umfasst einen Differenzblock 24 und eine Mehrzahl von in Reihe angeordneten Zeitverzögerungsblöcken 22. Im gezeigten Beispiel D (beispielsweise) 8 Stück. Auf diese Weise wird beispielsweise von dem Zwischensignal $S_R(n)$, das den Reduktionsblock 18 verlässt, im ersten Differentiationsblock das Zwischensignal $S_R(n-D)$, das D diskrete Zeitschritte zuvor erzeugt wurde, abgezogen.

Wenn der Reduktionsblock 18 nicht berücksichtigt wird, ist die z-Transformation einer CIC-Stufe (beispielsweise der ersten CIC-Stufe 12a)

$$H(z) = \frac{Y(z)}{X(z)} = \frac{1 - z^{-D}}{1 - z^{-1}} = \sum_{k=0}^{D-1} z^{-k}$$

Mit z= $e^{j2\pi f}$ stellt sich die Transferfunktion H(f) dar als

$$H(f) = H(z)\Big|_{z=e^{j2\pi f}} = \frac{1 - e^{-j2\pi fD}}{1 - e^{-j2\pi f}} = \frac{e^{-j2\pi fD/2}(e^{j2\pi fD/2} - e^{-j2\pi fD/2})}{e^{-j2\pi f/2}(e^{j2\pi f/2} - e^{-j2\pi f/2})} = e^{-j2\pi f(D-1)/2} \frac{\sin(\pi fD)}{\sin(\pi f)}$$

Das Zusammenhängen bzw. Verschachteln von M CIC-Stufen 12a, 12b führt zur Transferfunktion $H^M(f)$.

Die Fig. 2 zeigt die Transferfunktion 26 für ein CIC-Filter 10 mit zwei Stufen 12a, 12b und D = 8 (R = 1). In dem Diagramm der Fig. 2 ist nach rechts die Frequenz (Skalierung entspricht der Abtastrate) und nach oben die Dämpfung in dB aufgetragen. Wie aus der Fig. 2 hervorgeht, ist die Transferfunktion 26 kammförmig und dämpft periodische Bereiche eines Signals. Eine Reduktion der Abtastrate durch beispielsweise einen Faktor R = 4 führt zu einer periodischen Wiederholung des Spektrums in den Intervallen, die durch m * $f_s$ /4; m = 1, 2, ..., definiert sind, wobei $f_s$ die Abtastrate ist. Durch eine entsprechende Wahl des CIC-Filters 10 können somit ungewünschte periodische Spektralkomponenten entfernt oder zumindest stark gedämpft werden.

Auf diese Weise werden die Spektralkomponenten, die durch das Verändern der Abtastrate in dem Durchlassbereich des digitalen Filters 10 (beispielsweise den Bereich mit Frequenzen kleiner als 0,02) gefaltet werden würden, genügend stark gedämpft, wodurch ein ausreichendes Anti-Aliasing erzielt werden kann. Weiter ist die Dämpfung im Durchlassbereich des CIC-Filters 10 gering, so dass keine Kompensierung notwendig ist.

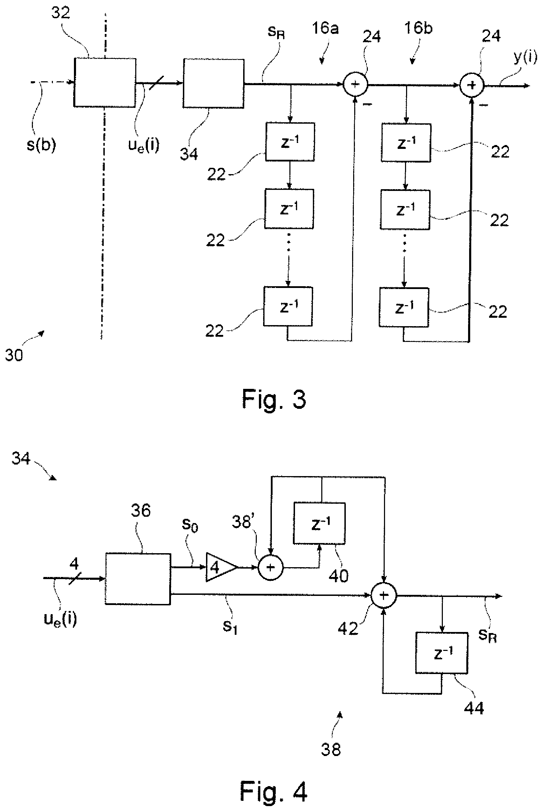

Die Fig. 3 zeigt nun ein digitales Reduktionsfilter 30, mit dem eine Dämpfung analog der Fig. 2 erzielt werden kann, das aber im Gegensatz zum Filter 10 einen Parallelisierungsblock 32 umfasst, mit dem das Eingangssignal s(k) in eine Mehrzahl von parallelen Rohsignalen $u_k(i)$, k = 0, ..., E-1 aufgespalten wird, deren Abtastrate um den entsprechenden Faktor geringer ist.

Beispielsweise werden durch den Parallelisierungsblock 32 aus dem seriellen Eingangssignal s(k) vier (im allgemeinen E) Rohsignale $u_k(i)$ erzeugt, deren Abtastrate um den Faktor 4 (bzw. E) geringer ist. Vor dem Parallelisierungsblock 32 hat das Signal eine Abtastrate von $f_s$, die Signale danach eine Abtastrate von $f_S/E$.

Auf diese Weise können die restlichen Komponenten des Filters 30 mit einer Hardware realisiert werden, die lediglich dazu ausgelegt ist, eine gegenüber der Abtastrate $f_s$ des Eingangssignals s(k) um diesen Faktor E niedrigere Abtastrate $f_s/E$ zu verarbeiten. Beispielsweise kann das Eingangssignal s(k) eine Abtastrate von etwa 1 GHz aufweisen und die Rohsignale $u_e(i)$ eine Abtastrate unter 300 MHz oder unter 200 MHz aufweisen. Derartige Abtastraten können beispielsweise von einem herkömmlichen FPGA verarbeitet werden.

Auf diese Weise ist das Reduktionsfilter 30 ausgeführt, auch hohe Abtastraten als Eingangssignal s(k) zu verarbeiten.

Genauso wie das Filter 10 umfasst das Filter 30 zwei Differentiationsblöcke 16a und 16b, die identisch aufgebaut sind. Die beiden Integrationsblöcke 14a und 14b sowie der Reduktionsblock 18 sind jedoch durch den Parallelisierungsblock 32 und einen Integrationsblock 34 ersetzt.

Der Integrationsblock 34 für den Fall E = 4 ist in der Fig. 4 dargestellt. Die vier Rohsignale $u_k(i)$ werden in einen Logikblock 36 eingespeist, der aus den vier Rohsignalen $u_k(i)$ zwei Summensignale $S_0$ und $S_1$ erzeugt, die dann einem Rekursionsblock 38 zugeführt werden. Alle Komponenten des Integrationsblocks 34 arbeiten mit einer Abtastrate von $f_s/4$.

Das Summensignal $S_0$ wird mit 4 multipliziert, und dann einem Additionsblock 38' zugeführt. Das Signal aus dem Additionsblock 38' wird mit einem zeitverzögerten Signal aus einem Zeitverzögerungsblock 40, der es um eine Zeiteinheit verzögert, mit dem ursprünglichen Signal addiert.

Analog wird das Summensignal S1 einem Additionsblock 42 zugeführt. Das Zwischensignal $S_R$ aus dem Additionsblock 42 wird mit einem zeitverzögerten Signal aus einem Zeitverzögerungsblock 44, der es um eine Zeiteinheit verzögert, mit dem ursprünglichen Signal addiert. Dem Additionsblock 42 wird auch das Signal aus dem Zeitverzögerungsblock 40, das auf dem Summensignal $S_0$ basiert, zugeführt.

Der Integrationsblock 34 ist nun so aufgebaut, dass er aus den parallelen Rohsignalen $u_e(i)$ das gleiche Zwischensignal $S_R$ erzeugt, wie die Komponenten 14a, 14b und 18 des Filters 10. Dies kann folgendermaßen hergeleitet werden:

Im Allgemeinen erzeugen diese Komponenten das folgende Signal

$$S_R(i) = \sum_{n=0}^{Ei-1} \sum_{k=0}^{n} s(k).$$

Die Integration bzw. Summation der ersten E parallelen Abtastwerte s(k) ergibt

$$\sum_{k=0}^{E-1} s(k) = S_0(1).$$

Diese Formel definiert $S_0(1)$.

Die zweimalige Integration der ersten E Abtastwerte ergibt

$$S_R(1) = \sum_{n=0}^{E-1} \sum_{k=0}^{n} s(k) = S_1(1)$$

Dies ist die Definition von $S_1(1)$. Wie später zu sehen sein wird, kann aus diesen beiden Signalen $S_0$, $S_1$ das Zwischensignal $S_R(i)$ rekursiv berechnet werden.

Die folgenden Berechnungen werden aus Gründen der Übersichtlichkeit nur für den Fall E = 4 durchgeführt. Die zweimalige Integration der ersten acht Abtastwerte ergibt

$$S_R(2) = \sum_{n=0}^{7}\sum_{k=0}^{n} s(k) = S_R(1) + \sum_{n=4}^{7}(\sum_{k=0}^{3} s(k) + \sum_{k=4}^{n} s(k)) = S_1(1) + 4\cdot\sum_{k=0}^{3} s(k) + \sum_{n=4}^{7}\sum_{k=4}^{n} s(k)$$

$$S_R(2) = S_R(1) + 4\cdot S_0(1) + \sum_{n=4}^{7}\sum_{k=4}^{n} s(k) = S_R(1) + 4\cdot S_0(1) + S_1(2)$$

Die zweimalige Integration der ersten 12 Abtastwerte ergibt

$$S_R(3) = \sum_{n=0}^{11}\sum_{k=0}^{n} s(k) = S_R(2) + \sum_{n=8}^{11}(\sum_{k=8}^{n} s(k) + \sum_{k=0}^{3} s(k) + \sum_{k=4}^{7} s(k)) = S_R(2) + S_1(3) + 4\cdot S_0(1) + 4\cdot S_0(2)$$

Basierend auf diesen Formeln kann eine rekursive Verarbeitung der zuvor definierten Signale definiert werden (wieder allgemein für E Rohsignale).

$$S_R(1) = S_1(1);$$

$$S_R(2) = S_R(1) + E\cdot S_0(1) + S_1(2);$$

$$S_R(i) = S_R(i-1) + S_1(i) + E\cdot S_0(i-2) + E\cdot S_0(i-1), i = 3,4,\ldots$$

wobei

$$S_0(i) = \sum_{e=0}^{E-1} u_k(i), i = 1,2,\ldots$$

$$S_1(i) = E\cdot u_0(i) + \ldots + 2\cdot u_{E-2}(i) + u_{E-1}(i), i = 1,2,\ldots$$

Die $u_e(i)$, e = 0, ..., E-1 sind dabei die E parallelen Eingangssignale für den Logikblock für den i-ten Abtastzeitpunkt der Abtastrate $f_s/E$.

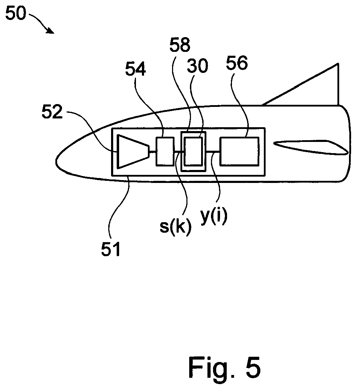

Die Fig. 5 zeigt den Radarsensor eines Lenkflugkörpers 50, in dem das Filter 30 eingesetzt werden kann. Der Lenkflugkörper 50 umfasst einen Radarsensor 51, der einen Radarempfänger 52, einen A/D-Wandler 54, eine digitale Signalverarbeitung 58 und eine Steuerelektronik 56 umfasst.

Der Radarempfänger 52 erzeugt ein analoges Signal, das von dem A/D-Wandler 54 in ein digitales Signal umgesetzt wird. Dieses digitale Signal wird der digitalen Signalverarbeitung 58 zugeführt, die den Filter 30 beinhaltet, der das Signal s(k) beispielsweise auf 1/4 der Abtastrate heruntersetzt und in das Signal y(i) umwandelt. Das Ausgangssignal der digitalen Signalverarbeitung 58 kann dann in der Steuerelektronik 56 des Lenkflugkörpers 50 weiterverarbeitet werden.

**Patentansprüche**

1. Digitales Filter (30) zum Reduzieren einer Abtastrate eines Eingangssignals (s), das digitale Filter (30) umfassend:

   einen Parallelisierungsblock (32) zum Aufspalten des Eingangssignals (s) in wenigstens zwei parallele Rohsignale ($u_e$),
   einen Integrationsblock (34) zum Umwandeln der parallelen Rohsignale ($u_e$) in ein Zwischensignal ($S_R$), und
   einen Differentiationsblock (16a, 16b) zum Erzeugen eines Ausgangssignals (y) durch Differenzieren des Zwischensignals ($S_R$),
   wobei der Integrationsblock (34) einen Logikblock (36) umfasst, der dazu ausgeführt ist, durch Summationsoperationen aus den parallelen Rohsignalen ($u_e$) zwei parallele Summensignale $S_0$ und $S_1$ zu erzeugen, **dadurch gekennzeichnet, dass** der Logikblock (36) die zwei parallelen Summensignale $S_0$ und $S_1$ gemäß

$$S_0(i) = \sum_{e=0}^{E-1} u_e(i), i = 1,2,\ldots$$

und

$$S_1(i) = E \cdot u_0(i) + \ldots + 2 \cdot u_{E-2}(i) + u_{E-1}(i), i = 1,2,\ldots$$

erzeugt, wobei $u_e(i)$ die parallelen Rohsignale und E die Anzahl der parallelen Rohsignale sind, und dass der Integrationsblock (34) einen Rekursionsblock (38) umfasst, der dazu ausgeführt ist, aus den parallelen Summensignalen ($S_0$, $S_1$) das Zwischensignal ($S_R$) rekursiv zu erzeugen, wobei das Zwischensignal $S_R$ gemäß

$$S_R(i) = S_R(i-1) + S_1(i) + E \cdot S_0(i-2) + E \cdot S_0(i-1), i = 3,4,\ldots$$

erzeugt wird.

2. Filter (30) nach Anspruch 1,
wobei die parallelen Summensignale ($S_0$, $S_1$) zu einem Abtastzeitpunkt aus den parallelen Rohsignalen zum gleichen Abtastzeitpunkt erzeugt werden.

3. Filter (30) nach einem der vorhergehenden Ansprüche,
wobei der Rekursionsblock (38) dazu ausgeführt ist, das Zwischensignal ($S_R$) zu einem Abtastzeitpunkt aus den parallelen Summensignalen ($S_0$, $S_1$) zu diesem Abtastzeitpunkt und wenigstens einem vorhergehenden Abtastzeitpunkt zu erzeugen.

4. Filter (30) nach einem der vorhergehenden Ansprüche,
wobei der Rekursionsblock (38) dazu ausgeführt ist, das Zwischensignal ($S_R$) zu einem Abtastzeitpunkt aus den parallelen Summensignalen ($S_0$, $S_1$) zu dem Abtastzeitpunkt und aus den parallelen Summensignalen ($S_0$, $S_1$), die um eine und zwei Zeiteinheiten verzögert wurden, zu erzeugen.

5. Filter (30) nach einem der vorhergehenden Ansprüche,
wobei der Parallelisierungsblock (32) dazu ausgeführt ist, das Eingangssignal (s) in wenigstens vier parallele Rohsignale ($u_e$) aufzuspalten.

6. Filter (30) nach einem der vorhergehenden Ansprüche,
wobei der Differentiationsblock zwei seriell angeordnete Differentiationsstufen (16a, 16b) aufweist, die dazu ausgeführt sind, das um eine vordefinierte Anzahl von Zeiteinheiten verzögerte Zwischensignal ($S_R$) von dem unverzögerten Zwischensignal ($S_R$) abzuziehen.

7. Filter (30) nach Anspruch 6,
wobei die Differentiationsstufen (16a, 16b) dazu ausgeführt sind, das Zwischensignal ($S_R$) um 4 oder 8 Zeiteinheiten zu verzögern.

8. Filter (30) nach einem der vorhergehenden Ansprüche,
wobei das Filter (30) in Hardware ausgeführt ist.

9. Radarsensor für einen Flugkörper (50), umfassend:

einen Radarempfänger (52),
einen A/D-Wandler (54) zum Wandeln eines analogen Signals aus dem Radarempfänger in ein digitales Signal,
eine digitale Signalverarbeitung, die ein digitales Filter (30) nach einem der Ansprüche 1 bis 10 zum Reduzieren der Abtastrate des digitalen Signals umfasst.

**10.** Verfahren zum Reduzieren einer Abtastrate eines Eingangssignals (s), das Verfahren umfassend die Schritte:

Aufspalten des Eingangssignals (s) in wenigstens zwei parallele Rohsignale ($u_e$);
Summieren der parallelen Rohsignale ($u_e$) zu zwei parallelen Summensignalen $S_0$ und $S_1$;
Erzeugen eines Zwischensignals ($S_R$) aus den parallelen Summensignalen ($S_0$, $S_1$);
Erzeugen eines Ausgangssignals (y) durch Differenzieren des Zwischensignals ($S_R$),
**dadurch gekennzeichnet, dass** die zwei parallelen Summensignale $S_0$ und $S_1$ gemäß

$$S_0(i) = \sum_{e=0}^{E-1} u_e(i), i = 1,2,...$$

und

$$S_1(i) = E \cdot u_0(i) + ... + 2 \cdot u_{E-2}(i) + u_{E-1}(i), i = 1,2,...$$

erzeugt werden, wobei $u_e(i)$ die parallelen Rohsignale und E die Anzahl der parallelen Rohsignale sind, und dass das Zwischensignal ($S_R$) aus den parallelen Summensignalen ($S_0$, $S_1$) rekursiv erzeugt wird, wobei das Zwischensignal $S_R$ gemäß

$$S_R(i) = S_R(i-1) + S_1(i) + E \cdot S_0(i-2) + E \cdot S_0(i-1), i = 3,4,...$$

erzeugt wird.

**Claims**

**1.** Digital filter (30) for reducing a sampling rate of an input signal (s) and said digital filter (30) comprises:

a parallelising block (32) for splitting the input signal (s) into at least two parallel raw signals ($u_e$),
an integration block (34) for converting the parallel raw signals ($u_e$) into an intermediate signal ($S_R$), and
a differentiation block (16a, 16b) for generating an output signal (y) by means of differentiating the intermediate signal ($S_R$),
wherein the integration block (34) comprises a logic block (36) that is configured so as to generate two parallel sum signals $S_0$ and $S_1$ from the parallel raw signals ($u_e$) by means of summation operations,
**characterised in that** the logic block (36) generates the two parallel sum signals $S_0$ and $S_1$ in accordance with

$$S_0(i) = \sum_{e=0}^{E-1} u_e(i), i = 1,2,...$$

and

$$S_1(i) = E \cdot u_0(i) + \cdots + 2 \cdot u_{E-2}(i) + u_{E-1}(i), i = 1,2,...$$

wherein $u_e(i)$ represents the parallel raw signals and E represents the number of the parallel raw signals, and that the integration block (34) comprises a recursion block (38) that is configured for the purpose of generating the intermediate signal ($S_R$) recursively from the parallel sum signals ($S_0$, $S_1$), wherein the intermediate signal $S_R$ is generated in accordance with

$$S_R(i) = S_R(i-1) + S_1(i) + E \cdot S_0(i-2) + E \cdot S_0(i-1), i = 3,4,...$$

2. Filter (30) according to claim 1,
wherein the parallel sum signals ($S_0$, $S_1$) at a sampling time are generated from the parallel raw signals at the same sampling time.

3. Filter (30) according to any one of the preceding claims, wherein the recursion block (38) is configured for the purpose of generating the intermediate signal ($S_R$) at a sampling time from the parallel sum signals ($S_0$, $S_1$) at this sampling time and at least one preceding sampling time.

4. Filter (30) according to any one of the preceding claims, wherein the recursion block (38) is configured for the purpose of generating the intermediate signal ($S_R$) at a sampling time from the parallel sum signals ($S_0$, $S_1$) at the sampling time and from the parallel sum signals ($S_0$, $S_1$) that are delayed by one or two time units.

5. Filter (30) according to any one of the preceding claims, wherein the parallelising block (32) is configured for the purpose of splitting the input signal (s) into at least four parallel raw signals ($u_e$).

6. Filter (30) according to any one of the preceding claims, wherein the differentiation block comprises two differentiation stages (16a, 16b) that are arranged in series and are configured for the purpose of subtracting an intermediate signal ($S_R$) that is delayed by a predefined number of time units from the intermediate signal ($S_R$) that is not delayed.

7. Filter (30) according to claim 6,
wherein the differentiation stages (16a, 16b) are configured for the purpose of delaying the intermediate signal ($S_R$) by 4 or 8 time units.

8. Filter (30) according to any one of the preceding claims, wherein the filter (30) is provided in hardware.

9. Radar sensor for a missile (50), said radar sensor comprising:

  a radar receiver (52),
  an A/D converter (54) for converting an analogue signal from the radar receiver into a digital signal,
  a digital signal processor that comprises a digital filter (30) according to any one of the claims 1 to 8 for reducing the sampling rate of the digital signal.

10. Method for reducing a sampling rate of an input signal (s) and said method comprises the following steps:

  splitting the input signal (s) into at least two parallel raw signals (ue),
  adding the parallel raw signals (Ue) to two parallel sum signals S0 and S1,
  generating an intermediate signal (SR) from the parallel sum signals (S0, S1),
  generating an output signal (y) by means of differentiating the intermediate signal (SR),
  **characterised in that** the two parallel sum signals S0 and S1 are generated in accordance with

$$S_0(i) = \sum_{e=0}^{E-1} u_e(i), i = 1, 2, \ldots$$

and

$$S_1(i) = E \cdot u_0(i) + \cdots + 2 \cdot u_{E-2}(i) + u_{E-1}(i), i = 1, 2, \ldots$$

  wherein $u_e(i)$ represents the parallel raw signals and E represents the number of the parallel raw signals, and that the intermediate signal (SR) is generated recursively from the parallel sum signals (S0, S1), wherein the intermediate signal SR is generated in accordance with

$$S_R(i) = S_R(i-1) + S_1(i) + E \cdot S_0(i-2) + E \cdot S_0(i-1), i = 3, 4, \ldots \quad .$$

**Revendications**

1.  Filtre numérique (30) pour réduire un taux d'échantillonnage d'un signal d'entrée (s), le filtre numérique (30) comprenant :

    un bloc de parallélisation (32) pour fractionner le signal d'entrée (s) en au moins deux signaux bruts parallèles ($u_e$),
    un bloc d'intégration (34) pour convertir les signaux bruts parallèles ($u_e$) en un signal intermédiaire ($S_R$), et
    un bloc de différentiation (16a, 16b) pour générer un signal de sortie (y) en différentiant le signal intermédiaire ($S_R$),
    dans lequel le bloc d'intégration (34) comprend un bloc logique (36) qui est configuré pour générer deux signaux additionnés parallèles $S_0$ et $S_1$ par des opérations d'addition à partir des signaux bruts parallèles ($u_e$),
    **caractérisé en ce que** le bloc logique (36) génère les deux signaux additionnés parallèles $S_0$ et $S_1$, selon

    $$S_0(i) = \sum_{e=0}^{E-1} u_e(i), i = 1,2,...$$

    et

    $$S_1(i) = E \cdot u_0(i) + ... + 2 \cdot u_{E-2}(i) + u_{E-1}(i), i = 1,2,...$$

    où $u_e(i)$ représente les signaux bruts parallèles et E le nombre de signaux bruts parallèles, et
    **en ce que** le bloc d'intégration (34) comprend un bloc de récurrence (38) qui est configuré pour générer de manière récurrente le signal intermédiaire ($S_R$) à partir des signaux additionnés parallèles ($S_0$, $S_1$), le signal intermédiaire $S_R$ étant généré selon

    $$S_R(i) = S_R(i-1) + S_1(i) + E \cdot S_0(i-2) + E \cdot S_0(i-1), i = 3,4,...$$

    .

2.  Filtre (30) selon la revendication 1,
    dans lequel les signaux additionnés parallèles ($S_0$, $S_1$) à un moment d'échantillonnage sont générés à partir des signaux bruts parallèles au même moment de l'échantillonnage.

3.  Filtre (30) selon une des revendications précédentes, dans lequel le bloc de récurrence (38) est configuré de manière à générer le signal intermédiaire ($S_R$) à un moment d'échantillonnage à partir des signaux additionnés parallèles ($S_0$, $S_1$) à ce moment de l'échantillonnage et au moins à un moment d'échantillonnage précédent.

4.  Filtre (30) selon une des revendications précédentes, dans lequel le bloc de récurrence (38) est configuré de manière à générer le signal intermédiaire ($S_R$) à un moment d'échantillonnage à partir des signaux additionnés parallèles ($S_0$, $S_1$) au moment de l'échantillonnage et à partir des signaux additionnés parallèles ($S_0$, $S_1$) qui ont été temporisés d'une ou de deux unités de temps.

5.  Filtre (30) selon une des revendications précédentes, dans lequel le bloc de parallélisation (32) est configuré de manière à fractionner le signal d'entrée (s) en au moins quatre signaux bruts parallèles ($u_e$).

6.  Filtre (30) selon une des revendications précédentes, dans lequel le bloc de différentiation présente deux niveaux de différentiation disposés en série (16a, 16b) qui sont configurés pour enlever du signal intermédiaire ($S_R$) non temporisé le signal intermédiaire ($S_R$) temporisé d'un nombre prédéfini d'unités de temps.

7.  Filtre (30) selon la revendication 6,
    dans lequel les niveaux de différentiation (16a, 16b) sont configurés de manière à temporiser le signal intermédiaire ($S_R$) de 4 ou 8 unités de temps.

**8.** Filtre (30) selon une des revendications précédentes, dans lequel le filtre (30) est configuré en tant que matériel.

**9.** Détecteur radar pour un missile (50), comprenant :

un récepteur radar (52),
un convertisseur analogique numérique (54) pour convertir un signal analogique en un signal numérique à partir de récepteurs radar,
un traitement de signal numérique qui comprend un filtre numérique (30) selon une des revendications 1 à 8 pour réduire le taux d'échantillonnage du signal numérique.

**10.** Procédé pour réduire un taux d'échantillonnage d'un signal d'entrée (s), le procédé comprenant les étapes :

fractionner le signal d'entrée (s) en au moins deux signaux bruts parallèles ($u_e$);
additionner les signaux bruts parallèles ($u_e$)en deux signaux additionnés parallèles $S_0$ et $S_1$ ;
générer un signal intermédiaire ($S_R$) à partir des signaux additionnés parallèles ($S_0$, $S_1$) ;
générer un signal de sortie (y) en différenciant le signal intermédiaire ($S_R$),
**caractérisé en ce que** les deux signaux additionnés parallèles $S_0$ et $S_1$ sont générés selon

$$S_0(i) = \sum_{e=0}^{E-1} u_e(i), i = 1,2,\dots$$

et

$$S_1(i) = E \cdot u_0(i) + \dots + 2 \cdot u_{E-2}(i) + u_{E-1}(i), i = 1,2,\dots$$

où $u_e(i)$ représente les signaux bruts parallèles et E le nombre de signaux bruts parallèles, et
**en ce que** le signal intermédiaire ($S_R$) est généré de manière récurrente à partir des signaux additionnés parallèles ($S_0$, $S_1$), le signal intermédiaire $S_R$ étant généré selon

$$S_R(i) = S_R(i-1) + S_1(i) + E \cdot S_0(i-2) + E \cdot S_0(i-1), i = 3,4,\dots$$

Fig. 1(Stand der Technik)

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040093366 A1
- EP 0707380 B1